# EUROPÄISCHE PATENTSCHRIFT

(11) **EP 1 210 984 B1**
(45) Veröffentlichungstag und Bekanntmachung des Hinweises auf die Patenterteilung: **16.06.2004**
(21) Anmeldenummer: 02003487.2
(22) Anmeldetag: 11.03.1995
(51) Int. Cl.: B05C 9/02

(54) **Verfahren und Vorrichtung zur Belackung oder Beschichtung eines Substrats**
Process and device for lacquering or coating a substrate
Procédé et dispositif de laquage ou d'enduction d'un substrat

(30) Priorität: 22.12.1994 DE 4445985
(43) Veröffentlichungstag der Anmeldung: 05.06.2002
(62) Teilanmeldung aus: 99120202.9
(73) Patentinhaber: Steag HamaTech AG, 75447 Sternenfels (DE)
(72) Erfinder: Appich, Karl, 75447 Sternenfels (DE); Stummer, Manfred, 74889 Sinsheim (DE)

(56) Entgegenhaltungen:
- WO-A-94/27737

## Beschreibung

Die Erfindung betrifft ein Verfahren und eine Vorrichtung zur Belackung oder Beschichtung eines Substrats mittels eines Kapillarspalts. Wenn im folgenden bei der Beschreibung der Erfindung vereinfachend nur von Belackung bzw. von Belackungsvorgängen gesprochen wird, so sind damit auch Beschichtung bzw. Beschichtungsvorgänge mit geeigneten Fluiden gemeint, also mit geeigneten Lacken oder geeigneten Beschichtungsflüssigkeiten.

Im Bereich der Dünnschichttechnik, insbesondere bei der Herstellung von LCD-Bildschirmen, von Masken für die Halbleiterfertigung, Halbleiter- oder Keramiksubstraten etc. ergibt sich häufig die Aufgabe, rechteckige oder runde Platten mit einer gleichmäßigen Schicht aus Lack oder anderen zunächst flüssigen Medien zu versehen, z.B. mit Farbfiltern, Fotolacken, oder mit speziellen Schutzschichten. Nach dem Stand der Technik. werden dabei die Platten zur Belackung horizontal auf einem Drehtelter befestigt. Auf den Mittelpunkt der Platte wird von oben über eine Düse eine bestimmte Lackmenge aufgetropft. Danach wird der Drehteller in Bewegung gesetzt. Durch die Zentrifugalkraft wird der Lack während der Drehbewegung auf dem Substrat verteilt ("spin coating"). Dabei wird ein großer Teil des Lackes über den Rand des Substrats weggeschleudert. Die erreichbare Gleichförmigkeit der Lackdicke hängt von der Größe der Drehbeschleunigung, der Drehgeschwindigkeit, sowie von der Viskosität des Lackes ab.

Schwierigkeiten mit der Gleichförmigkeit der Lackdicke auf rechteckigen, plattenförmigen Substraten gibt es bei diesem bekannten Verfahren vor allem im Bereich der Ränder der Substrate. Dort bilden sich gewöhnlich Streifen höherer Lackdicke, nämlich sogenannte Lackwulste. Hierdurch wird die Gleichmäßigkeit der Belackung wesentlich verschlechtert.

Um den Lack aufzufangen, der über den Rand des Substrates hinausgeschleudert wird, und um die Belackungsstation zu schützen, werden solche Belackungs-Drehteller gewöhnlich in eine Art Topf eingebaut, vgl. z.B. das DE-GM 91 03 494. Während des Belackens können Rückspritzer auch auf die Oberflächen der Substrate gelangen. Dies ist für die Weiterverarbeitung der Substrate ungünstig. Bei diesem bekannten Verfahren werden zudem bis über 90 % der verwendeten Lackmenge über den Rand der Substrate weggeschleudert; diese Lackmenge kann nur mit sehr hohem Aufwand wiederverwendet werden. Die Größe der Platten, die belackt bzw. beschichtet werden können, ist nach oben hin begrenzt. Ferner können an den rotierenden Teilen solcher Vorrichtungen kleine Partikel abgerieben und abgelöst werden, die sich auf den Oberflächen der Platten ablagern und nachfolgende Prozesse stören. Außerdem gelangt während des Schleuderprozesses Lack an die Substratkante, und das kann bei nachfolgenden Prozessen zu Problemen führen. Zudemist der gesamte Aufbau und der Antrieb eines solchen Drehtellers aufwendig und teuer.

Eine Verbesserung der Belackungs- und Beschichtungsvorgänge wurde durch eine Vorrichtung zur Belackung und Beschichtung von Platten (PCT/DE 93/00777) erreicht, bei der die Belackungs- bzw. Beschichtungsflüssigkeit - im folgenden Fluid genannt - über einen zu einer Kapillare verengten Spalt von unten an die nach unten weisende Oberfläche eines Substrats herangeführt wird. Das Substrat wird mit gleichförmiger Geschwindigkeit über den Spalt hinweggeführt. Der Spalt ist so ausgebildet, dass er als Kapillare wirkt und somit den Lack selbsttätig und mit besonders gleichförmiger Geschwindigkeit nachliefert. Die Kapillarwirkung wird dadurch erreicht, dass der Spalt beispielsweise weniger als 0,5 mm breit ist. Durch die Kapillarwirkung steigt das Fluid selbsttätig mit konstanter Geschwindigkeit entgegen der Schwerkraft in dem Kapillarspalt nach oben und tritt an dessen Austrittsöffnung aus. Oberhalb des Spaltes trifft der Lackstrom als schmale Linie auf die zu beschichtende Fläche des Substrats und lagert sich, während das Substrat relativ zur Austrittsöffnung bewegt wird, auf dieser Fläche als gleichmäßige Schicht ab.

Der Belackungs- bzw. Beschichtungsvorgang erfolgt somit durch eine kombinierte Ausnutzung von Kapillar- und Adhäsionseffekten. Mit dieser Vorrichtung lässt sich die Gleichmäßigkeit der Lackschichtdicke insbesondere auf rechteckförmigen Substraten verbessern, und der Lackverbrauch nimmt ab. Nachteilig kann sich auswirken, dass durch die Adhäsionswirkung an der Endkante des zu belackenden bzw. zu beschichtenden Substrats ein unerwünschter Wulst aus Lack oder Beschichtungsmaterial entsteht.

Zum Benetzen einer zu verklebenden Fläche mit Klebstoff ist aus der DE-A-2204625 eine Benetzungsvorrichtung bekannt. Bei ihr ist in einem Behälter mit dem Klebstoff eine Anordnung mit parallel nebeneinander gestellten Blechen in Form eines Blechpakets bekannt. Durch Kapillarwirkung steigt der Klebstoff zwischen den Blechen dieses Blechpakets hoch, und eine darauf gelegte zu verklebende Fläche wird blitzartig mit dem Klebstoff benetzt. Jedoch ist bei einer solchen Anordnung die Benetzung mit Klebstoff nicht gleichförmig.

Auch kennt man aus der WO 94127737 ein Verfahren zur Beschichtung einer Glasplatte für einen LCD-Bildschirm mit einer Schicht aus Fotolack. Dabei wird die um 11° zur Horizontalen geneigte Glasplatte, beginnend an ihrer höchsten Stelle, über eine Schlitzdüse mit den Maßen 350 mm x 2 mm hinweggeführt, und dieser Schlitzdüse wird mittels einer Pumpe, und über ein Rücksaugventil, Fotolack zugeführt. Am Ende einer Beschichtung wird die Pumpe abgeschaltet, und durch das Rücksaugventil wird der Fotolack aus der Schlitzdüse abgesaugt.

Eine Aufgabe der vorliegenden Erfindung wird darin gesehen, ein neues Verfahren und eine neue Vorrichtung zur gleichförmigen Belackung und Beschichtung von Substraten bereit zu stellen.

Nach der Erfindung wird diese Aufgabe gelöst durch ein Verfahren gemäß Patentanspruch 1. Durch das Absenken des Fluids im Behälter wird also das Fluid im Kapillarspalt abgesenkt, und dadurch wird die Belackung unterbrochen, ohne dass ein Lackwulst am betreffenden Rand des Substrats entsteht.

Eine Vorrichtung zur Durchführung eines solchen Verfahrens ist Gegenstand des Anspruchs 2. Durch die Erzeugung des Unterdrucks wird das Fluid schnell im Kapillarspalt abgesenkt, so dass die Entstehung eines Wulstes an einer Endkante des Substrats reduziert oder vermieden werden kann.

Besonders vorteilhaft lässt sich ein solches Zurücksaugen des Fluids dadurch erreichen, dass in dem im Behälter befindlichen Fluid ein Bauteil angeordnet ist, dessen Volumen veränderbar ist. Wird dieses Volumen verkleinert, so sinkt der Flüssigkeitspegel im Behälter ab. Dies erzeugt einen Unterdruck im Kapillarspalt, der das dort befindliche Fluid nach unten zurücksaugt.

Mit Vorteil geht man dabei so vor, dass die Austrittsöffnung des Kapillarspalts durch eine in Höhenrichtung erfolgende Bewegung vollständig in das Fluid eintauchbar ist. Man kann so in den Zeiten zwischen Belackungsvorgängen die Austrittsöffnung des Kapillarspalts vollständig in das Fluid eintauchen. Dabei wird verhindert, dass eventuelle Fluidreste, die von einem Belackungsvorgang an oder auf dem Kapillarspalt zurückgeblieben sind, antrocknen, und dass sich dort Partikel von außen anlagern. Beides könnte sonst zu Störungen während eines späteren Belackungsvorganges führen.

Die Beweglichkeit der Austrittsöffnung, wie sie Gegenstand des Anspruchs 7 ist, ermöglicht es, diese zu Beginn einer Belackung an das Substrat besonders eng heranzuführen und sie am Ende der Belackung wieder vom Substrat zu entfernen.

Auch hat es sich als sehr vorteilhaft erwiesen, eine Filtriervorrichtung und eine Pumpe vorzusehen, um im Behälter befindliches Fluid im Umlauf zu filtrieren. Man kann so über ein Feinstpartikelfilter das Fluid filtrieren (Umlauffiltration), um es sauber und in einem für die Belackungszwecke geeigneten Zustand zu erhalten. Dabei ist mit Vorteil die Filtrierung während eines Beschichtungs- oder Belackungsvorganges unterbrochen.

Weitere Einzelheiten und vorteilhafte Weiterbildungen der Erfindung ergeben sich aus den im folgenden beschriebenen und in der Zeichnung dargestellten, in keiner Weise als Einschränkung der Erfindung zu verstehenden Ausführungsbeispielen, sowie aus den Unteransprüchen. Es zeigt:
- Fig. 1: einen Querschnitt durch eine erfindungsgemäße Vorrichtung, bei der sich das einen Kapillarspalt bildende Bauteil in einem untergetauchten Zustand befindet,
- Fig. 2: einen Querschnitt durch die Vorrichtung der Fig. 1, bei der das den Kapillarspalt bildende Bauteil während eines Belackungsvorganges aus dem Fluid im Behälter herausgetaucht ist, gesehen längs der Linie II-II der Fig. 3,
- Fig. 3: einen Längsschnitt durch einen Teil einer erfindungsgemäßen Vorrichtung mit ausgetauchtem Kapillarspaltbauteil, während eines Belackungsvorganges,
- Fig. 4: eine teilweise im Schnitt dargestellte, raumbildliche Darstellung eines bevorzugten Ausführungsbeispiels einer erfindungsgemäßen Vorrichtung,
- Fig. 5: eine Einzelheit der Fig. 4, ebenfalls in raumbildlicher Darstellung,
- Fig. 6: einen Schnitt, gesehen längs der Linie VI-VI der Fig. 8, in einem gegenüber Fig. 6 vergrößerten Maßstab,
- Fig. 7: eine raumbildliche Darstellung der Einzelheit VII der Fig. 6,
- Fig. 8: einen Längsschnitt durch die in Fig. 4 dargestellte Vorrichtung,
- Fig. 9: eine raumbildliche Darstellung der in Fig. 4 dargestellten Vorrichtung, wobei sich der Kapillarspalt in seiner Arbeitsstellung befindet, gesehen von oben, und
- Fig. 10: eine raumbildliche Darstellung analog Fig. 9, aber gesehen von unten.

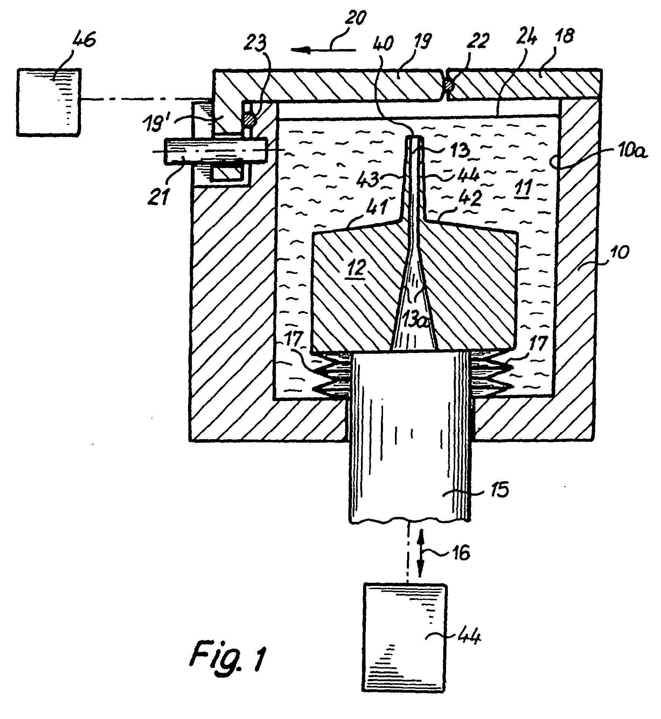

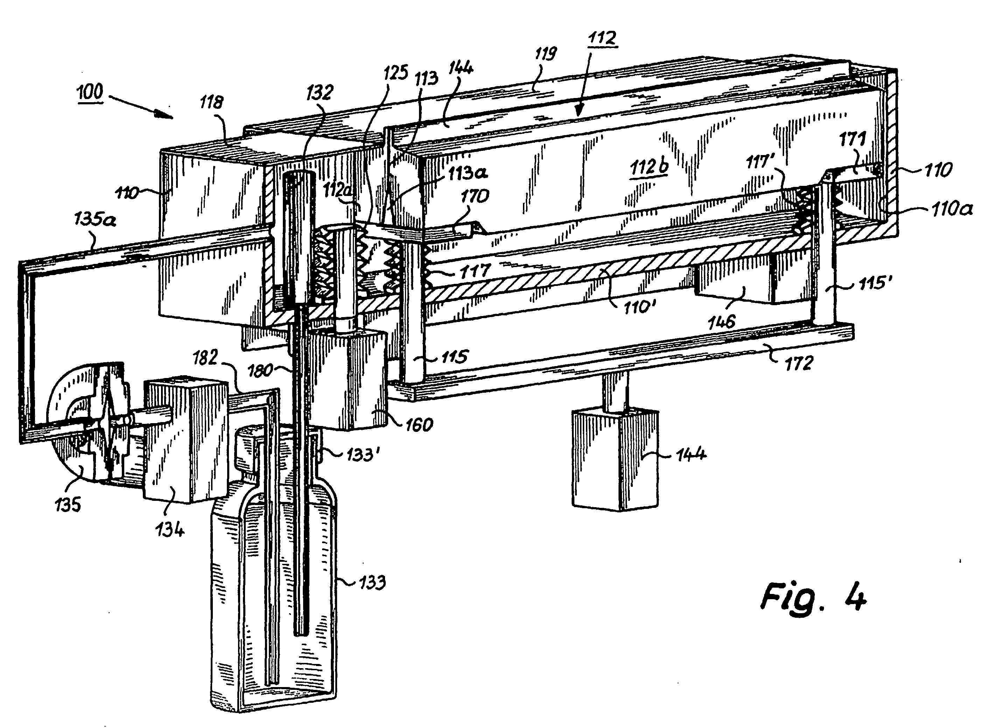

Zunächst wird anhand der Fig. 1 bis 3 das Grundprinzip der vorliegenden Erfindung an schematischen Darstellungen erläutert. Anschließend wird dann anhand der Fig. 4 bis 10 ein praktisches Ausführungsbeispiel der Erfindung dargestellt, das nach diesem Grundprinzip arbeitet.

Fig. 1 zeigt einen Schnitt durch einen Behälter 10, dessen Hohlraum 10a weitgehend mit Lack oder Beschichtungsmittel 11, im folgenden "Fluid" genannt, gefüllt ist. Im Behälter 10, der etwa die Form einer länglichen Rinne oder eines länglichen Troges hat, befindet sich ein längliches Bauteil 12, das einen für den Belackungsvorgang notwendigen Kapillarspalt 13 enthält. Dieser hat gewöhnlich eine Breite im Bereich von 0,1 bis 0,8 mm, und er wird durch einen senkrecht verlaufenden Schlitz im Bauteil 12 gebildet, der sich nach unten hin bei 13a erweitert, um das ungehinderte Zuströmen des Fluids 11 zum Kapillarspalt 13 zu ermöglichen.

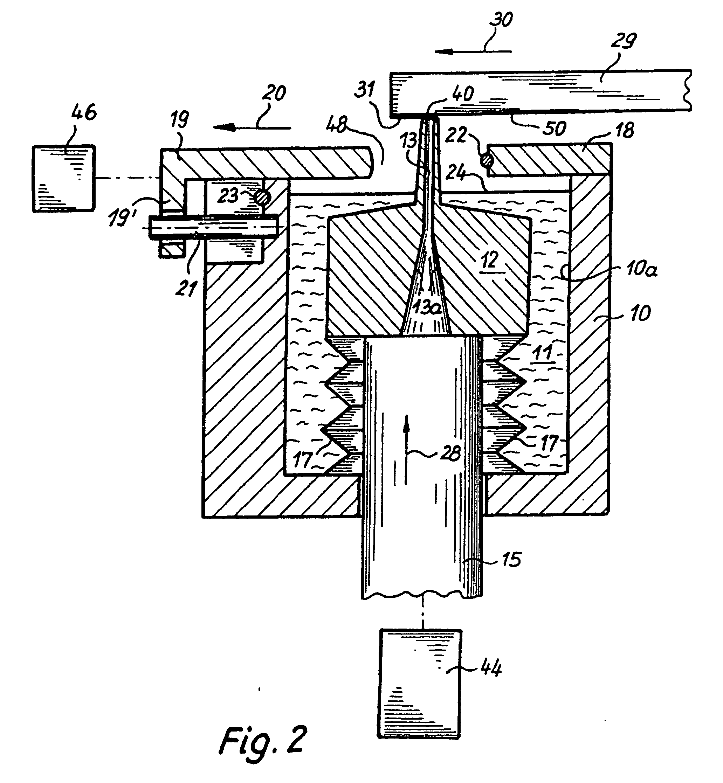

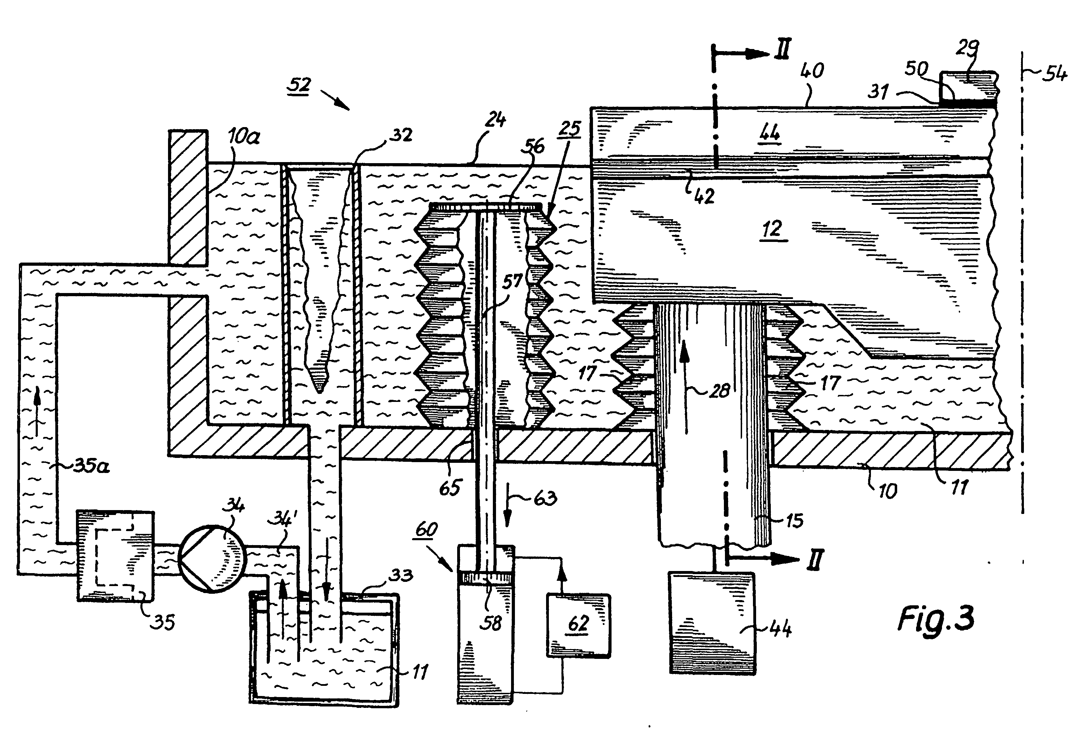

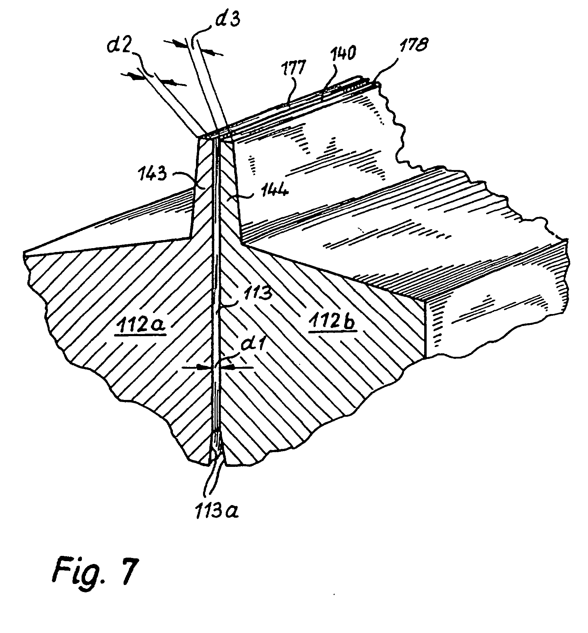

Am oberen Ende des Bauteils 12 hat der Kapillarspalt 13 eine Austrittsöffnung 40, die man auch als Düse bezeichnen könnte und die nachfolgend anhand der Fig. 7 noch im Detail dargestellt wird. Je nach der Breite eines zu beschichtenden Substrats 29 (Fig. 2 und 3) kann diese Austrittsöffnung 40 eine Länge im Bereich von z.B. 50 bis 75 cm haben, wobei naturgemäß auch längere oder kürzere Längen nicht ausgeschlossen sind.

Das Bauteil 12 hat im wesentlichen die Form eines im Querschnitt etwa rechteckförmigen Grundkörpers, der nach oben hin durch zwei schräg abfallende, dachartige Flächen 41, 42 begrenzt wird, und in dessen Mitte zwei messerartige Fortsätze 43, 44 nach oben ragen, von denen jeder im Bereich der Düse 40 nur eine Breite von etwa 0,1...0,5 mm hat.Diese Fortsätze 43, 44 verjüngen sich also nach oben hin und sinddort äußerst schmal.

Das Bauteil 12 ist an seiner Unterseite mit einer Stange 15 verbunden. Diese kann über eine nur schematisch dargestellte Vorrichtung 44 in Richtung eines Pfeiles 16 vertikal verschoben werden. Dadurch kann das Bauteil 12 in vertikaler Richtung bewegt werden. Der Hohlraum 10a des Behälters 10 ist gegen die Durchführung der Stange 15 durch seinen Boden in der dargestellten Weise mit einem Faltenbalg 17 abgedichtet, der im Schnitt rechts und links von der Stange 15 zu sehen ist. Als Vorrichtung 44 eignet sich z.B. ein hydraulischer oder pneumatischer Arbeitszylinder.

Der Hohlraum 10a des Behälters 10 ist rechts oben (Fig. 1 und 2) durch eine feststehende Platte 18 und links oben durch ein verschiebbares Winkelprofil 19 verschlossen. Die Platte 18 ist direkt auf der rechten Seitenwand des Behälters 10 befestigt. Das Winkelprofil 19 ist mittels einer nur schematisch dargestellten linearen Antriebsvorrichtung 46 seitlich in Richtung eines Pfeiles 20 (Fig. 1) verschiebbar. Die Führung dieser Verschiebebewegung kann beispielsweise, wie dargestellt, über einen Führungsbolzen 21 erfolgen, der an der linken Seitenwand des Behälters 10 befestigt ist.

Der Verschluss des Hohlraums 10a wird durch zwei Elastomerprofile 22 und 23 abgedichtet. Das Profil 22 ist in eine geeignete Nut in der Stirnseite der Platte 18 eingelegt und wird durch die Stirnseite des Winkelprofils 19 in der in Fig. 1 dargestellten Weise angepresst. Das Dichtungsprofil 23 ist in eine geeignete Nut in der linken Seitenwand des Behälters 10 eingelegt und wird durch einen vertikal verlaufenden Schenkel 19' des Winkelprofils 19 angepresst. Der Anpressdruck wird von der Vorrichtung 46 aufgebracht, welche das Winkelprofil 19 verschiebt. Alternativ können die Platte 18 und das Winkelprofil 19 mit einem geeigneten, lösungsmittelfesten Kunststoff überzogen sein, Dicke z.B. 0,5 mm, der dann im geschlossenen Zustand die Abdichtfunktionen übernimmt.

Das Bauteil 12 mit seinem Kapillarspalt 13 ist in Fig. 1 völlig unter die Oberfläche 24 des Fluids 11 eingetaucht dargestellt. Dies entspricht einem Zustand, bei dem nicht belackt wird, d.h. die Austrittsöffnung 40 des Bauteils 12 befindet sich unterhalb der Oberfläche 24 des Fluids 11.

In Fig. 2 ist derselbe Querschnitt des Behälters 10 mit sämtlichen Einbauten wie in Fig. 1 dargestellt, jedoch während eines Belackungsvorganges. Der aus Platte 18 und Winkelprofil 19 bestehende Verschluss des Hohlraums 10a ist dadurch geöffnet, dass das Winkelprofil 19 im Vergleich zur Darstellung der Fig. 1 in Richtung des Pfeiles 20 nach links verschoben ist. Das Bauteil 12 mit seinem Kapillarspalt 13 wurde durch eine senkrechte Bewegung der Stange 15 in Richtung eines Pfeiles 28 nach oben bewegt. Dadurch ragen die messerartigen Fortsätze 43, 44 nunmehr über die Oberfläche 24 des Fluids im Behälter 10 hinaus und durch eine schmale Öffnung 48 zwischen Platte 18 und Winkelprofil 19 hindurch. Dies entspricht dem Zustand während eines Belackungsvorganges. Durch die schmale Form der messerartigen Fortsätze 43, 44 wird erreicht, dass die Öffnung 48 sehr schmal sein kann, was die Gefahr verringert, dass Verunreinigungen durch die Öffnung 48 in das Fluid 11 gelangen. Auch wird hierdurch die Verdunstung des Fluids 11 reduziert.

In Fig. 2 ist auch ein zu belackendes Substrat 29 (in Form einer Platte) während eines Belackungsvorganges dargestellt. Dieses Substrat 29 wird mit gleichförmiger Geschwindigkeit in Richtung eines Pfeiles 30 in sehr geringem Abstand (z.B. 0,2 ... 0,5 mm) über die Austrittsöffnung 40 des Kapillarspalts 13 hinweggeführt. Dabei scheidet sich durch Kapillarwirkung und Adhäsion eine sehr gleichförmige Lackschicht 31 auf der Unterseite 50 des Substrats 29 ab. Im nassen Zustand liegt die Dicke der Lackschicht 31 typischerweise im Bereich von 5 bis 50 µm.

In Fig. 3 ist ein Längsschnitt durch einen Teil des Behälters 10 und des Bauteils 12 während eines Belackungsvorganges dargestellt. Das Bauteil 12 ist, ebenso wie in der Darstellung der Fig. 2, in Richtung des Pfeiles 28 nach oben gefahren. An der Unterseite 50 des zu belackenden Substrats 29 scheidet sich eine gleichförmige Lackschicht 31 ab. Die Dicke dieser Schicht 31 ist zur Veranschaulichung stark übertrieben dargestellt.

Der Teillängsschnitt der Fig. 3 zeigt einen linken Abschnitt 52 des Behälters 10 sowie des Bauteils 12, und die zu dessen vertikalem Antrieb dienende Stange 15. Spiegelbildlich dazu gibt es auch am rechten Ende des Behälters 10 eine der Stange 15 entsprechende zweite Stange, die in Fig. 3 nicht dargestellt ist. Eine Spiegelebene ist symbolisch bei 54 dargestellt. Die gesamte Länge des Bauteils 12 kann, wie bereits erläutert, z.B.50 bis 75 cm betragen, wobei die äußeren Randbereiche, wie in Fig. 3 dargestellt, nicht für die Belackung verwendet werden. Durch parallele Auf- und Abbewegungen der Stangen 15 wird sichergestellt, dass die Austrittsöffnung (Düse) 40 des Kapillarspalts 13 immer in der notwendigen, genau horizontalen Lage bleibt.

In Fig. 3 ist außerdem ein Überlaufrohr 32 im Schnitt dargestellt. Sobald nach Einschalten einer Pumpe 34 die Füllhöhe des Fluids 11 im Hohlraum 10a die Oberkante dieses Überlaufrohres 32 erreicht, beginnt dort Fluid abzufließen. Es gelangt durch das Überlaufrohr 32 in einen Ausgleichsbehälter 33, z.B. eine Vorratsflasche, welche z.B.2,5 I des Fluids 11 enthält. Die Pumpe 34 ist über ein Rohr 34' an den Behälter 33 angeschlossen und saugt aus diesem Fluid 11 an. Von der Pumpe 34 gelangt das Fluid 11 über ein Feinstfilter 35 und eine Leitung 35a zurück in den Hohlraum 10a. Pumpe 34 und Filter 35 sind handelsübliche Komponenten und daher nur schematisch dargestellt.

Durch Umpumpen des Fluids 11 zwischen den Belackungs- bzw. Beschichtungsvorgängen wird dieses gereinigt, und sein Füllstand 24 im Behälter 10 wird konstant auf einer vorgegebenen Höhe gehalten. Beides ist für die Qualität des Belackungs- bzw. Beschichtungsvorgangs wichtig. Während des Belackungs- bzw. Beschichtungsvorgangs wird das Fluid 11 nicht durch das Filter 35 gepumpt, da eine Strömung im Behälter 10 das Belackungs- bzw. Beschichtungsergebnis negativ beeinflussen könnte. Bei der Belackung eines Substrats 29 werden gewöhnlich zwischen 1 und 3 ml des Fluids 11 verbraucht, wodurch der Flüssigkeitsspiegel 24 nur ganz wenig absinkt, z.B. um 0,1 bis 0,4 mm, was bei der Belackung nicht stört.

Innerhalb des Hohlraums 10a befindet sich außerdem ein Faltenbalg 25. Seine obere Abschlussplatte 56 ist über eine Stange 57, welche den Boden des Behälters 10 durchdringt, mit dem Kolben 58 eines Arbeitszylinders 60 verbunden, der mittels einer schematisch dargestellten Vorrichtung 62 betätigt werden kann.

Wird durch Betätigung der Vorrichtung 62 (diese erfolgt gewöhnlich durch eine zentrale Steuerung mittels eines nicht dargestellten Mikroprozessors) der Kolben 58 in Richtung eines Pfeiles 63 nach unten verschoben, so bewegt sich die obere Abschlussplatte 56 des Faltenbalgs 25 nach unten, und das Volumen des Faltenbalgs 25 wird verkleinert, wobei durch eine Öffnung 65 im Boden des Behälters 10 Luft nach unten entweichen kann. Dadurch sinkt der Flüssigkeitsspiegel 24 im Behälter 10 rasch ab. Wird umgekehrt die obere Abschlussplatte 56 mittels des Arbeitszylinders 60 nach oben bewegt, so steigt der Flüssigkeitsspiegel 24 bis zu einem Maximalwert, der durch das Überlaufrohr 32 vorgegeben ist.

Somit kann durch entsprechende Steuerung der Vorrichtung 62 der Flüssigkeitsstand 24 im Behälter 10 rasch entsprechend den Bedürfnissen verändert werden.

### Arbeitsweise

Sobald ein zu belackendes Substrat 29 für den Beginn eines Belackungsvorganges positioniert ist, wird die Abdeckung des Behälters 10 geöffnet, indem das Winkelprofil 19 durch die Vorrichtung 46 nach links verschoben wird. Anschließend werden die messerartigen Fortsätze 43, 44 des Bauteils 12 nach oben bis auf einen sehr geringen Abstand von z.B. 0,05 mm unter die Vorderkante des zu belackenden Substrats 29 herangefahren. Da hierbei die Pumpe 34 abgeschaltet ist, sinkt der Flüssigkeitsspiegel 24 geringfügig ab, z.B. um 0,1 bis 0,5 mm, was aber nicht stört. Das geringe Absinken ist eine Folge davon, dass die aus dem Fluid 11 heraustauchenden messerartigen Fortsätze 43, 44 nur ein geringes Volumen haben, was hier sehr vorteilhaft ist.Durch die Bewegung des Bauteils 12 wird ein Kontakt hergestellt zwischen dem kleinen Fluidwulst einerseits, der von dem Tauchbad über der Austrittsöffnung 40 des Kapillarspalts 13 verblieben ist, und andererseits der vorderen Unterkante des zu belackenden Substrats 29. Nach der Herstellung dieses Kontakts wird der Abstand zwischen der Austrittsöffnung 40 des Bauteils 12 und dem zu belackenden bzw. zu beschichtenden Substrat 29 wieder etwas vergrößert, z.B. auf ca. 0,2 bis 0,5 mm. Damit wird der Kapillareffekt in Gang gesetzt, der das Fluid 11 entgegen der Schwerkraft mit gleichförmiger Geschwindigkeit durch den Kapillarspalt 13 nach oben transportiert. Jetzt wird das Substrat 29 mit gleichförmiger Geschwindigkeit waagerecht in Richtung des Pfeiles 30 in Bewegung gesetzt. Hierbei wird eine gleichförmige, dünne Fluidschicht 31 durch den Kapillarspalt 13 hindurch auf der Unterseite des Substrats 29 abgeschieden.

Ist die (nicht dargestellte) Endkante des zu belackenden Substrats 29 erreicht, so wird der Faltenbalg 25 in der bereits beschriebenen Weise rasch verkleinert, z.B. innerhalb einer Sekunde. Dadurch sinkt der Flüssigkeitsspiegel 24 im Hohlraum 10a rasch ab. (Die Pumpe 34 steht hierbei still.) Auf diese Weise entsteht im Kapillarspalt 13 ein Unterdruck, der das im Kapillarspalt 13 enthaltene Fluid 11 nach unten saugt. Dies bewirkt, dass die Fluidabscheidung auf der Unterseite der Platte 29 plötzlich beendet und eine unerwünschte Wulstbildung an der (nicht dargestellten) Endkante des Substrats 29 sicher verhindert wird. Durch die äußerst schmale Form der messerartigen Fortsätze 43, 44 im Bereich der Düse 40 wird erreicht, dass sich an der Endkante des Substrats 29 keine Lackwülste oder dergleichen bilden.

Anschließend wird das Bauteil 12 wieder nach unten in den Behälter 10 zurückgefahren, und die Abdeckung aus Platte 18 und Winkelprofil 19 wird wieder geschlossen, um den Innenraum des Behälters 10 nach außen hin luftdicht abzuschließen und eine Verdunstung des Fluids 11 im Hohlraum 10a zu verhindern.

Nach dem Schließen der Abdeckung (durch Verschieben des Winkelprofils 19 nach rechts) wird die Pumpe 34 eingeschaltet. Das bei der Belackung verbrauchte Fluid 11 wird somit wieder dem Hohlraum 10a zugeführt. Sobald die notwendige Füllhöhe des Fluids 11 erreicht ist, beginnt dieses wieder durch das Überlaufrohr 32 in den Ausgleichsbehälter 33 abzufließen. Durch den Kreislauf wird das Fluid 11 gefiltert. Der Zeitraum, während dessen die Pumpe 34 eingeschaltet ist, beträgt im allgemeinen nur wenige Sekunden. Wird jedoch festgestellt, dass das Fluid 11 verunreinigt ist, so kann man die Pumpe 34 auch längere Zeit laufen lassen, um das Fluid mittels des Filters 35 zu reinigen. Der Vorratsbehälter 33 muss von Zeit zu Zeit ersetzt werden, wenn das Fluid in ihm verbraucht ist. Ein großer Vorteil der Erfindung ist der sehr sparsame Verbrauch an Fluid, z.B. nur etwa 1 bis 3 ml pro zu beschichtender Platte 29. - Als Vorratsbehälter 33 kann die Flasche verwendet werden, in der das Fluid 11 von seinem Hersteller geliefert wird.

Naturgemäß sind vielfache Abwandlungen und Modifikationen möglich. Z.B. könnte das Teil 12 auch durch eine Drehbewegung um seine Längsachse aus der Stellung gemäß Fig. 2 in seine untergetauchte Stellung gebracht werden. Eine vertikale Verschiebung des Bauteils 12 wird jedoch derzeit bevorzugt, um unerwünschte, unsymmetrische Strömungsvorgänge im Fluid während der Belackung nach Möglichkeit zu vermeiden.

Eine erfindungsgemäße Vorrichtung kann einen Teil einer größeren Belackungsanlage bilden, wie sie z.B. in PCT/DE93/00777 dargestellt ist. Auf den Inhalt dieser PCT-Anmeldung wird deshalb zur Vermeidung von Längen ausdrücklich Bezug genommen.

Die Fig. 4 bis 10 zeigen eine bevorzugte Ausführungsform einer erfindungsgemäßen Vorrichtung 100. Gleiche Teile wie in den Fig. 1 bis 3 werden mit denselben Bezugszeichen bezeichnet wie dort, aber um die Zahl 100 erhöht, also z.B. 113 statt 13.

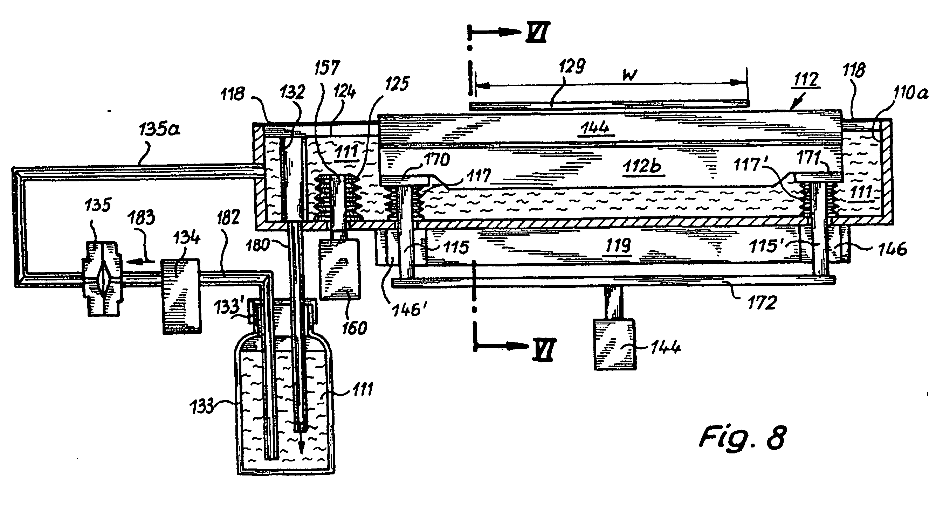

Fig. 4 zeigt die Vorrichtung 100 im Längsschnitt und in raumbildlicher Darstellung. Diese Vorrichtung hat einen länglichen, trogartigen Behälter 110, dessen Boden mit 110' bezeichnet ist. Sein Hohlraum 110a ist, wie in Fig. 8 dargestellt, bis zur Höhe eines Überlaufrohres 132 mit einem Fluid 111 gefüllt. Der Fluidspiegel ist in Fig. 8 mit 124 bezeichnet.

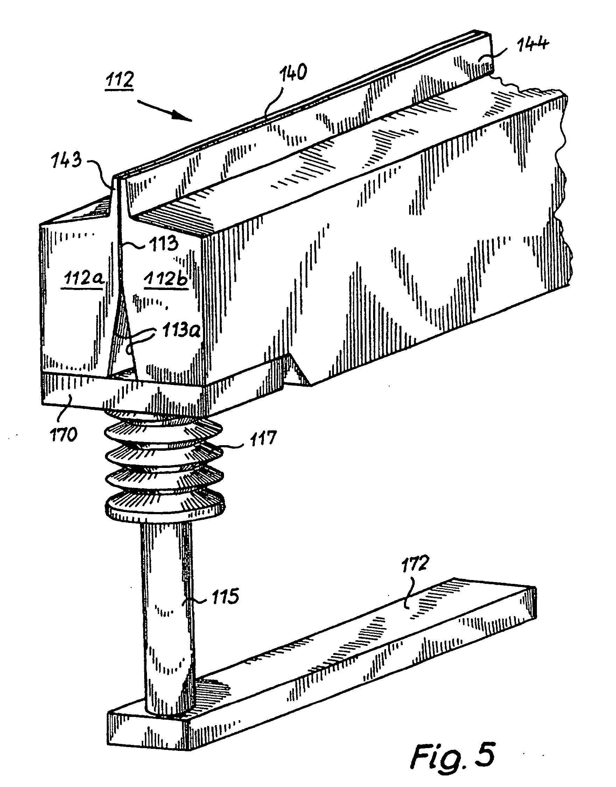

Im Behälter 110 befindet sich ein längliches Bauteil 112, das gemäß Fig. 5 aus zwei symmetrischen Hälften 112a, 112b zusammengesetzt ist, die durch einen Kapillarspalt 113 voneinander getrennt sind. Dieser Kapillarspalt 113 hat gemäß Fig. 7 eine Breite d1, die je nach verwendetem Fluid 111 ca. 0,1 bis 0,8 mm beträgt. Der Kapillarspalt 113 erweitert sich an seinem unteren Bereich zu einer im Querschnitt trichterförmigen Erweiterung 113a, die in den Fig. 4, 5 und 6 dargestellt ist. Sie erleichtert die Zufuhr des Fluids 111 zum Kapillarspalt 113.

Wie die Fig. 4, 5, 6 und 8 besonders gut zeigen, sind die symmetrischen Hälften 112a, 112b in ihrem Mittelbereich in vertikaler Richtung breiter ausgeführt, um eine Durchbiegung zu vermeiden. An ihren beiden Enden sind sie weniger hoch, und dort sind sie in geeigneter Weise, z.B. mittels (nicht dargestellter) Schrauben auf Montageplatten 170 bzw. 171 befestigt, die ihrerseits mit einer zylindrischen Stange 115 bzw. 115' verbunden sind. Diese Stangen durchdringen den Boden 110' des Behälters 110 und sind an ihren unteren Enden durch einen Querverbinder 172 miteinander verbunden, und dieser ist mittels einer Vorrichtung 144 in vertikaler Richtung verschiebbar, wodurch das Bauteil 112 gehoben und gesenkt werden kann, wie das anhand der Fig. 1 und 2 für das Bauteil 12 bereits ausführlich beschriebenwurde. Die Vorrichtung 144 kann ein beliebiger Linearantrieb sein, z.B. ein Pneumatikzylinder oder ein elektrischer Linearantrieb.

Die Stangen 115, 115' sind mittels Faltenbälgen 117, 117' in der dargestellten Weise abgedichtet, ebenso, wie in den Fig. 1 bis 3 anhand des Faltenbalgs 17 bereits auführlich erläutert.

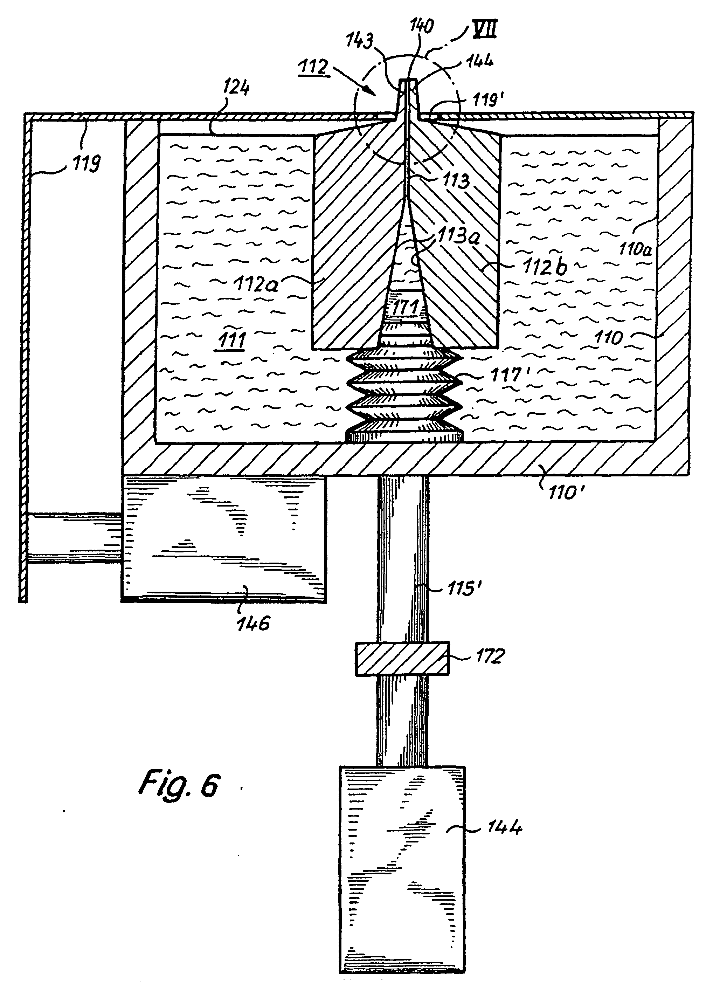

Wie die Fig. 5 und 6 besonders gut zeigen, haben die Hälften 112a, 112b des länglichen Körpers 112 an ihren oberen Enden jeweils einen messerartigen Fortsatz 143 bzw. 144, der im wesentlichen vertikal nach oben ragt. Jeder dieser Fortsätze 143, 144 endet oben in einer schmalen, im Betrieb waagerechten Fläche 177 bzw. 178 (Fig. 7), in welcher der Kapillarspalt 113 als Öffnung 140 mündet. Diese Öffnung 140 und die sie umgebenden Flächen 177, 178 können auch als Düse bezeichnet werden.

Die Fläche 177 hat gemäß Fig. 7 eine Breite d₂, welche zwischen 0,1 und 0,5 mm liegt und bevorzugt 0,3 mm beträgt. Die Fläche 178 hat eine Breite d₃ (Fig. 7), die zwischen 0,1 und 0,5 mm liegt und bevorzugt 0,3 mm beträgt. Der Vorteil dieser schmalen Flächen 177, 178 liegt darin, dass durch sie die Entstehung eines Fluidwulstes an der rückwärtigen Kante eines zu beschichtenden Substrats 129 weitgehend vermieden werden kann. Ein solches Substrat ist in Fig. 8 dargestellt. Seine Breite W ist kleiner als die Länge des Bauteils 12, d.h. für eine gleichförmige Beschichtung wird nur der mittlere Längenbereich W des Bauteils 112 ausgenutzt. In den Randbereichen könnten Diskontinuitäten der Fluidschicht (31 in den Fig. 1 bis 3) entstehen.

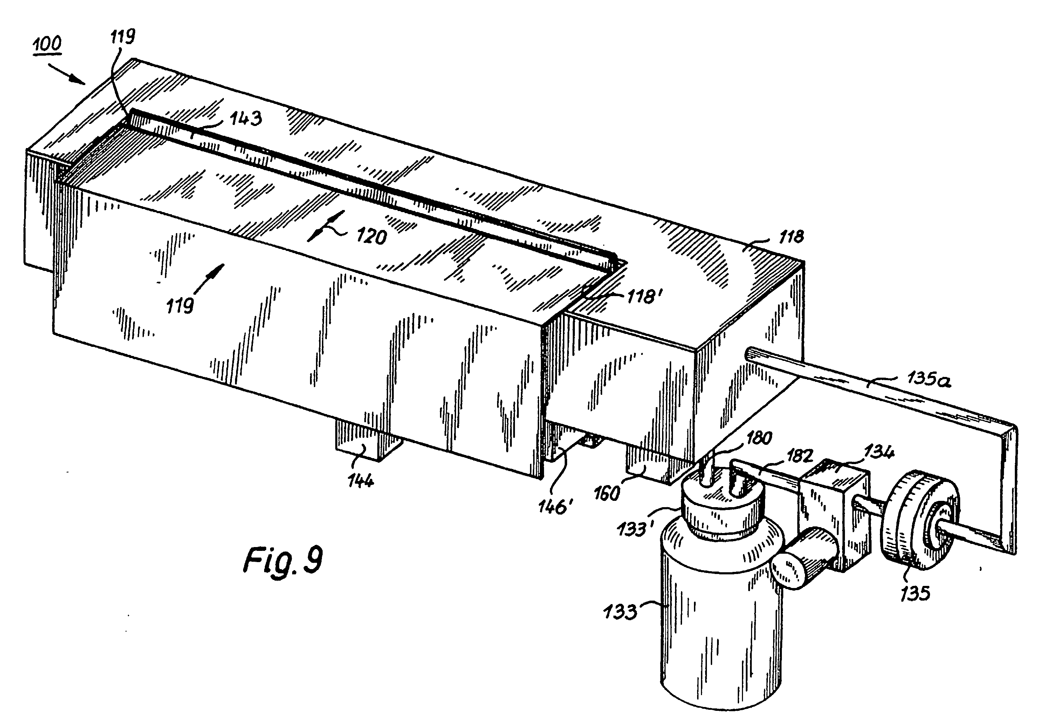

Wie man Fig. 9 entnimmt, ist der größte Teil der Oberseite des Behälters 110 durch eine Abdeck- und Abdichtplatte 118 überdeckt. Diese hat eine rechteckförmige Aussparung 118', und in diese ist eine verschiebbare Winkelplatte 119 eingepasst, die dort in Richtung eines Pfeiles 120 in horizontaler Richtung verschiebbar ist. Wird sie in Fig. 9 nach vorne verschoben, so bildet sie eine Öffnung 119', durch welche die messerartigen Fortsätze 143, 144 für einen Belackungsvorgang nach oben geschoben werden können. Wird die Winkelplatte 119 in Fig. 9 nach hinten verschoben, so schließt sie die Öffnung 119' vollständig und dichtend ab. Hierzu können beide Platten 118 und 119 mit einem lösungsmittelfesten Kunststoff (nicht dargestellt) überzogen sein, der z.B. 0,5 mm dick ist und der an den Rändern die gewünschte Abdichtung bewirkt.

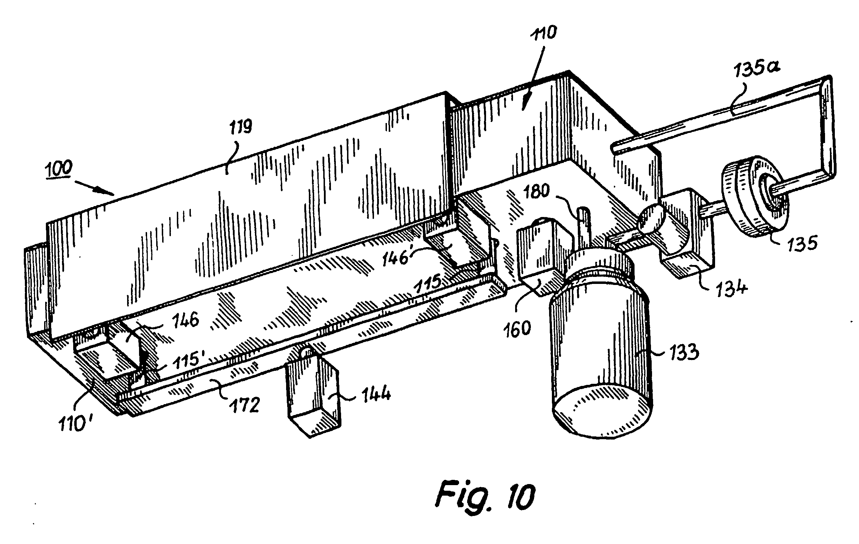

Zum horizontalen Verschieben der Winkelplatte 119 dienen zwei lineare Antriebsglieder 146, 146' (Fig. 10), die synchron miteinander betätigt werden, um eine gleichmäßige Verschiebung der Winkelplatte 119 zu erreichen.

Im Hohlraum 110a des Behälters 110 befindet sich auch ein Faltenbalg 125, dessen Volumen mittels eines Betätigungsgliedes 160 verändert werden kann. Wird dieses Volumen dadurch verändert, dass eine Betätigungsstange des Faltenbalgs 125 in Richtung nach unten bewegt wird, so bewirkt dies eine rasche Absenkung des Fluidniveaus 124 im Behälter 110, wodurch das Fluid im Kapillarspalt 113 nach unten gesaugt und ein Belackungsvorgang beendet wird. Wird die Stange 157 nach oben bewegt, so steigt das Fluidniveau 124 rasch an.

An das Überlaufrohr 132 ist ein nach unten führendes Rohr 180angeschlossen, das durch einen Deckel 133' in das Innere einer Vorratsflasche 133 für das Fluid 111 führt. Aus dieser Flasche 133 führt, ebenfalls durch den Deckel 133', ein Saugrohr 182 zu einer Pumpe 134, welche nur betätigt werden kann, wenn kein Belackungsvorgang stattfindet. Diese Pumpe 134 fördert Fluid in Richtung eines Pfeiles 183 (Fig. 8) zu einem Feinstfilter 135, und von diesem durch eine Leitung 135a zurück zum Innenraum 110a des Behälters 110.

Ist die Winkelplatte 119 in ihrem (nicht dargestellten) geschlossenen Zustand, in dem sie die Oberseite des Behälters 10 hermetisch abschließt, so kann die Pumpe 134 betätigt werden. Sie pumpt dann Fluid 111 aus dem Vorratsbehälter 133 durch das Feinstfilter 135 in den Hohlraum 110a des Behälters 110 und füllt diesen dadurch bis zur Höhe des Überlaufrohres 132 (Fig. 8) auf. (Bei einem Belackungsvorgang sinkt das Fluidniveau 124 geringfügig ab, da für die Belackung eine kleine Menge an Fluid verbraucht wird.)

### Arbeitsweise

Sobald ein zu belackendes Substrat 129 für den Beginn eines Belackungsvorganges positioniert ist, wird die Abdeckung des Behälters 110geöffnet, indem die Winkelplatte 119 durch die beiden Vorrichtungen 146, 146' in Öffnungsrichtung verschoben wird. Anschließend werden die messerartigen Fortsätze 143, 144 des Bauteils 112 mittels des Antriebs 144 nach oben bis auf einen sehr geringen Abstand von z.B. 0,05 mm unter die Vorderkante des zu belackenden Substrats 129 herangefahren. Dadurch wird ein Kontakt hergestellt zwischen dem kleinen Fluidwulst einerseits, der von dem Fluid 111 im Behälter 110 über der Austrittsöffnung 140 des Kapillarspalts 113 verblieben ist, und andererseits der vorderen Unterkante des zu belackenden Substrats 129. Nach der Herstellung dieses Kontakts wird der Abstand zwischen der Austrittsöffnung 140 des Bauteils 112 und dem zu belackenden bzw. zu beschichtenden Substrat 129 wieder etwas vergrößert, z.B. auf ca. 0,2 bis 0,5 mm. Damit wird der Kapillareffekt in Gang gesetzt, der das Fluid 111 aus dem Behälter 110 entgegen der Schwerkraft mit gleichförmiger Geschwindigkeit durch den Kapillarspalt 113 nach oben transportiert. Jetzt wird das Substrat 129 mit gleichförmiger Geschwindigkeit waagerecht in Bewegung gesetzt, wie bei Fig. 2 ausführlich beschrieben. Hierbei wird eine gleichförmige, dünne Fluidschicht durch den Kapillarspalt 113 hindurch auf der Unterseite des Substrats 129 abgeschieden. Diese Schicht hat im feuchten Zustand gewöhnlich eine Dicke zwischen 5 und 50 µm.

Ist die (nicht dargestellte) Endkante des zu belackenden Substrats 129 erreicht, so wird der Faltenbalg 125 in der bereits beschriebenen Weise rasch verkleinert, z.B. innerhalb einer Sekunde. Dadurch sinkt der Flüssigkeitsspiegel 124 im Hohlraum 110a rasch ab. (Die Pumpe 134 steht hierbei still.) Auf diese Weise entsteht im Kapillarspalt 113 ein Unterdruck, der das dort befindliche Fluid 111 nach unten absaugt. Dies bewirkt, dass die Fluidabscheidung auf der Unterseite des Substrats 129 plötzlich beendet und eine unerwünschte Wulstbildung an der (nicht dargestellten) Endkante des Substrats 129 sicher verhindert wird. Durch die äußerst schmale Form der messerartigen Fortsätze 143, 144 im Bereich der Öffnung 140 wird erreicht, dass sich an der Endkante des Substrats 129 keine Lackwülste oder dergleichen bilden.

Anschließend wird das Bauteil 112 mittels des Antriebs 144 wieder nach unten in den Behälter 110 zurückgefahren, wo es vollständig in das Fluid 111 untergetaucht wird, und die Öffnung 119' wird durch die Winkelplatte 119 wieder hermetisch verschlossen, um den Innenraum des Behälters 110 nach außen abzudichten und so eine Verdunstung des Fluids 111 im Hohlraum 110a zu verhindern.

Nach dem Verschließen der Öffnung 119' wird die Pumpe 134 eingeschaltet, und dadurch wird das bei einem Belackungsvorgang verbrauchte Fluid 111 wieder dem Hohlraum 110a zugeführt. Sobald dort die richtige Füllhöhe erreicht ist, beginnt das Fluid 111 wieder durch das Überlaufrohr 132 in den Vorrats- und Ausgleichsbehälter 133 abzufließen. Durch den Kreislauf wird das Fluid 111 durch das Feinstfilter 135 gefiltert. Die Pumpe wird zu diesem Zwecke gewöhnlich nur wenige Sekunden eingeschaltet, kann jedoch zwecks Reinigung des Fluids 111 auch länger eingeschaltet werden. Der Vorratsbehälter 133 wird durch eine neue Flasche ersetzt, wenn das in ihm befindliche Fluid 111 verbraucht ist. Hierzu wird eine neue Flasche 133 von unten an den feststehenden Deckel 133' angeschraubt. Ein großer Vorteil der Erfindung ist der äußerst sparsame Verbrauch von Fluid 111 und der Wegfall der Notwendigkeit, Fluidreste zu entsorgen.

Naturgemäß sind im Rahmen der Erfindung vielfache Abwandlungen und Modifikationen möglich. So kann naturgemäß der Verschluss des Behälters 110 auf verschiedene Arten bewerkstelligt werden, z.B. auch durch Aufsetzen eines Deckels von oben. Auch kann man alternativ das Substrat 129 von oben her an die Öffnung 140 des Bauteils 112 heranführen, statt umgekehrt diese Öffnung 140 an die Unterseite des Substrats 129 heranzuführen.

Ebenso könnte statt des Faltenbalgs 125 z.B. eine Pumpe vorgesehen sein, welche rasch Fluid 111 aus dem Behälter 110 absaugt, um das Fluidniveau 124 rasch abzusenken, wobei diese Pumpe ganz einfach als Hohlraum eines Arbeitszylinders ausgebildet sein kann. Dies wäre analog dem Vorgang, wie man vor einer Injektion die zu injizierende Flüssigkeit in eine Injektionsspritze ansaugt. In beiden Fällen (Pumpe oder Zylinder) kann die Flüssigkeit anschließend wieder in den Behälter 110 zurückgepumpt werden, z.B. durch Umkehr der Förderrichtung dieser (nicht dargestellten) Pumpe.

## Patentansprüche

1. Verfahren zum Belacken oder Beschichten eines Substrats mittels eines einen Kapillarspalt aufweisenden Bauteils und eines über diesen Kapillarspalt zugeführten Fluids, mit folgenden Schritten:
Das Fluid wird dem Substrat über den Kapillarspalt des Bauteils von unten aus einem das Fluid enthaltenden Behälter durch Kapillarwirkung zugeführt;
am Ende der Belackung oder Beschichtung wird das Niveau (24; 124) des Fluids im Behälter (10; 110) abgesenkt und dadurch im Kapillarspalt des Bauteils ein Unterdruck erzeugt, der das im Kapillarspalt des Bauteils enthaltende Fluid nach unten saugt, um den Vorgang der Belackung oder Beschichtung zu unterbrechen.

2. Vorrichtung zur Belackung oder Beschichtung eines Substrats (29; 129) mittels eines einen Kapillarspalt (13; 113) aufweisenden Bauteils (12; 112), zur Durchführung eines Verfahrens nach Anspruch 1,
mit einem Lack oder Beschichtungsflüssigkeit - im folgenden Fluid (11; 111) genannt - enthaltenden Behälter (10; 110), in welchem das Bauteil (12; 112) so angeordnet ist, dass der Kapillarspalt (13; 113) des Bauteils (12; 112) mit dem Fluid (11; 111) im Behälter in Verbindung steht und dieses Fluid dem Kapillarspalt (13; 113) des Bauteils (12; 112) von unten aus dem Behälter (10; 110) durch Kapillarwirkung zuführbar ist,
und mit Mitteln (25; 125) zur Absenkung des Niveaus (24; 124) des Fluids im Behälter (10; 110) zur Erzeugung eines Unterdrucks im Kapillarspalt (13; 113) des Bauteils (12; 112), um das im Kapillarspalt des Bauteils enthaltene Fluid (11; 111) nach unten zu saugen, um den Vorgang der Belackung oder Beschichtung zu unterbrechen.

3. Vorrichtung nach Anspruch 2, bei welcher in dem im Behälter (10; 110) befindlichen Fluid (11; 111) ein Bauteil (25; 125) angeordnet ist, dessen Volumen veränderbar ist, um das Niveau (24; 124) des Fluids im Behälter (10; 110) durch Reduzierung dieses Volumens absenken zu können.

4. Vorrichtung nach Anspruch 3, bei welcher das Bauteil als Balg (25; 125) ausgebildet ist.

5. Vorrichtung nach Anspruch 4, bei welcher das Volumen des Balgs (25; 125) durch einen Linearantrieb (60; 160) veränderbar ist.

6. Vorrichtung nach einem der Ansprüche 2 bis 5, bei welcher die Austrittsöffnung (40; 140) des Kapillarspalts (13; 113) durch eine in Höhenrichtung erfolgende Bewegung vollständig in das Fluid (11; 111) eintauchbar ist (Fig. 1).

7. Vorrichtung nach einem der Ansprüche 2 bis 6, bei welcher die Austrittsöffnung (40; 140) des Kapillarspalts (13; 113) durch eine in Höhenrichtung erfolgende Bewegung an die Unterseite (50) eines Substrats (29; 129) heranführbar ist, oder umgekehrt.

8. Vorrichtung nach einem der Ansprüche 2 bis 7, bei welcher eine Filtriervorrichtung (35; 135) und eine Pumpe (34; 134) vorgesehen sind, um im Behälter (10; 110) befindliches Fluid (11; 111) im Umlauf zu filtrieren.

## Claims

1. Method of lacquering or coating a substrate by means of a component having a capillary gap and a fluid fed by way of this capillary gap, comprising the following steps: the fluid is fed to the substrate by way of the capillary gap of the component from below from a container, which contains the fluid, by capillary action; at the end of the lacquering or coating the level (24; 124) of the fluid in the container (10; 110) is reduced and there is thereby produced in the capillary gap of the component an underpressure which sucks the fluid, which is contained in the capillary gap of the component, downwardly in order to interrupt the process of lacquering or coating.

2. Device for lacquering or coating a substrate (29; 129) by means of a component (12; 112) having a capillary gap (13; 113), for carrying out a method according to claim 1, with a container (10; 110) which contains lacquer or coating liquid - called fluid (11; 111) in the following - and in which the component (12; 112) is so arranged that the capillary gap (13; 113) of the component (12; 112) stands in connection with the fluid (11; 111) in the container and this fluid can be fed to the capillary gap (13; 113) of the component (12; 112) from below from the container (10; 110) by capillary action, and with means (25; 125) for lowering the level (24; 124) of the fluid in the container (10; 110) for producing an underpressure in the capillary gap (13; 113) of the component (12; 112) so as to suck the fluid (11; 111), which is contained in the capillary gap of the component, downwardly in order to interrupt the process of lacquering or coating.

3. Device according to claim 2, in which a component (25; 125), the volume of which is variable, is arranged in the fluid (11; 111) disposed in the container (10; 110), in order to be able to lower the level (24; 124) of the fluid in the container (10; 110) by reducing this volume.

4. Device according to claim 3, in which the component is constructed as a bellows (25; 125).

5. Device according to claim 4, in which the volume of the bellows (25; 125) is variable by a linear drive (60; 160).

6. Device according to one of claims 2 to 5, in which the outlet opening (40; 140) of the capillary gap (13; 113) is completely immersible in the fluid (11; 111) by a movement carried out in height direction (Fig. 1).

7. Device according to one of claims 2 to 6, in which the outlet opening (40; 140) of the capillary gap (13; 113) can be guided to the underside (50) of a substrate (29; 129) or conversely by a movement carried out in height direction.

8. Device according to one of claims 2 to 7, in which a filter device (35; 135) and a pump (34; 134) are provided in order to filter fluid (11; 111), which is disposed in the container (10; 110), in circulation.

## Revendications

1. Procédé de vernissage ou d'enduction d'un substrat à l'aide d'un composant comportant une fente capillaire et un fluide amené par l'intermédiaire de cette fente capillaire, avec les étapes suivantes :
le fluide est amené vers le substrat par l'intermédiaire de la fente capillaire du composant à partir du bas, à partir d'un récipient contenant le fluide par capillarité ;
à la fin du vernissage ou d'enduction, le niveau (24 ; 124) du fluide dans le récipient (10 ; 110) a baissé et une pression négative est ainsi générée dans là fente capillaire du composant, qui aspire le fluide contenu dans la fente capillaire vers le bas, afin d'interrompre le processus de vernissage ou de revêtement.

2. Dispositif pour le vernissage ou l'enduction d'un substrat (29 ; 129) au moyen d'un composant (12 ; 112) présentant une fente capillaire (13 ; 113), pour la réalisation d'un procédé selon la revendication 1,
avec un récipient (10 ; 110) contenant une laque ou un liquide de recouvrement - appelé ci-après fluide (11 ; 111) - dans lequel le composant (12 ; 112) est disposé de façon à ce que la fente capillaire (13 ; 113) du composant (12 ; 112) soit en liaison avec le fluide (11 ; 111) dans le récipient et que ce fluide puisse être amené vers la fente capillaire (13 ; 113) du composant (10 ; 110),
et avec des moyens (25 ; 125) pour baisser le niveau (24 ; 124) du fluide dans le récipient (10 ; 110) pour générer une pression négative dans la fente capillaire (13 ; 113)du composant (12 ; 112), pour aspirer le fluide (11 ; 111) contenu dans la fente capillaire du composant, afin d'interrompre le processus de vernissage ou d'enduction.

3. Dispositif selon la revendication 2, où est disposé dans le fluide (11 ; 111) se trouvant dans le récipient (10 ; 110) un composant (25 ; 125) dont le volume est modifiable pour faire baisser le niveau (24 ; 124) du fluide dans le récipient (10 ; 110) par la réduction de ce volume.

4. Dispositif selon la revendication 3, où le composant est réalisé sous forme de soufflet (25 ; 125).

5. Dispositif selon la revendication 4, où le volume du soufflet (25 ; 125) est modifiable par une commande linéaire (60 ; 160).

6. Dispositif selon l'une des revendications 2 à 5, où l'ouverture de sortie (40 ; 140) de la fente capillaire (13 ; 113) peut être plongée par un mouvement effectué dans le sens de la hauteur complètement dans le fluide (11 ; 111) (fig. 1).

7. Dispositif selon l'une des revendications 2 à 6, où l'ouverture de sortie (40 ; 140) de la fente capillaire (13 ; 113) peut être amenée par un mouvement effectué dans le sens de là hauteur au côté inférieur (50) d'un substrat (29 ; 129), ou inversement.

8. Dispositif selon l'une des revendications 2 à 7, où sont prévus un dispositif de filtrage (35 ; 135) et une pompe (34 ; 134) pour filtrer par circulation le fluide (11 ; 111) se trouvant dans le récipient (10 ; 110).
